Europäisches Patentamt

**European Patent Office**

**Office européen des brevets**

(11) Publication number: **0 090 576**
A2

# EUROPEAN PATENT APPLICATION

(21) Application number: **83301578.7**

(22) Date of filing: **22.03.83**

(51) Int. Cl.³: **H 03 K 13/18**

(30) Priority: **30.03.82 JP 50060/82**

(43) Date of publication of application: **05.10.83**
**Bulletin 83/40**

(84) Designated Contracting States: **DE FR GB**

(71) Applicant: **Fanuc Ltd, 5-1, Asahigaoka, 3-chome,**
**Hino-shi, Tokyo 191 (JP)**

(72) Inventor: **Amemiya, Yoichi, 1019-357 Nishiterakata-cho,**
**Hachioji-shi Tokyo (JP)**
Inventor: **Takekoshi, Yoshitaka, Akutagawa**
**Kopo 201, 3-3-20, Asahigaoka Hino-shi Tokyo (JP)**

(74) Representative: **Allman, Peter John et al, Marks and**
**Clerk Scottish Life House Bridge Street, Manchester**
**M3 3DP (GB)**

(54) **A pulse encoder.**

(57) A pulse encoder for determining the angle of rotation or the rotating speed of a servomotor, comprising an input optical fiber and at least one output optical fiber and not comprising a light source, a light-receiving semiconductor element, and a signal amplifier having semiconductor elements, whereby the resolution of the pulse encoder is not deteriorated due to an increase in the temperature of the motor.

ACTORUM AG

- 1 -

A PULSE ENCODER

BACKGROUND OF THE INVENTION

Field of the Invention

The present invention relates to a pulse encoder and more particularly to an optical pulse encoder for determining the angle of rotation or the rotating speed of a servometer.

Description of the Prior Art

A conventional pulse encoder comprises a light source, a rotary lattice disc, a stationary lattice plate, a light-receiving semiconductor element, e.g., a photo diode, a signal amplifier, and a rectangular waveform converter. A lamp or a light-emitting diode (LED) is used as the light source. The light from the light source passes through the transparent portions of the rotary lattice disc and through the transparent portions of the stationary lattice plate to reach the light-receiving semiconductor element. The light-receiving semiconductor element converts the received light into an electric signal. The electric signal is amplified by the signal amplifier and then is converted into a signal having a rectangular waveform.

Generally, a pulse encoder is assembled inside a motor for the purpose of determining the angle of rotation or the rotating speed of the motor. When a conventional pulse encoder is assembled in a motor, a problem exists in that the pulse encoder is exposed to an increasingly high temperature as the temperature of the motor increases, resulting in a lowered output of the LED when the LED is used as the light source or in a lowered reliability of the light-receiving semiconductor element or of the semiconductor elements in the signal amplifier.

A problem also exists in regard to the transmission of signals. That is, the output signal of the signal amplifier is transferred through an electrically conductive signal cable. When the conductive signal cable is extended so that it is several tens of meters, the signal level is lowered due to the resistance of the signal cable, noises are

- 2 -

supplied to the signal cable due to external electromagnetic induction, or the waveform of the signal at the end of the signal cable is deteriorated due to the floating capacitances of the signal cable.

SUMMARY OF THE INVENTION

Accordingly, an object of the present invention is to provide a pulse encoder employing optical fibers and lenses instead of employing a light source, a light-receiving semiconductor element, and a signal amplifier.

Another object of the present invention is to provide such a pulse encoder as mentioned above, the output signal from the pulse encoder being transmitted by optical fibers instead of by an electrically conductive signal cable.

Still another object of the present invention is to provide such a pulse encoder as mentioned above, wherein the reliability of the operation of the pulse encoder is improved.

Still a further object of the present invention is to provide such a pulse encoder as mentioned above, wherein the transmission characteristics of the output signal are improved.

To attain the above-mentioned objects, in a pulse encoder provided according to the present invention, light rays from an external light source are transmitted into an optical fiber and are converted into parallel light rays by a lens. A part of the parallel light rays are transmitted through a rotary lattice disc and a stationary lattice plate and thereby are modified into alternating light intervals and dark intervals. The modified light rays are also transmitted to the outside of the pulse encoder by optical fibers.

BRIEF DESCRIPTION OF THE DRAWINGS

The above objects and advantages of, as well as other features of, the present invention will be better understood from the following description of the preferred embodiments made with reference to the accompanying drawings, wherein:

Fig. 1 is a vertical cross-sectional view of a

- 3 -

pulse encoder according to an embodiment of the present invention;

Fig. 2 is a plan view of a rotary lattice disc included in the pulse encoder of Fig. 1;

Fig. 3 is a plan view of a stationary lattice plate included in the pulse encoder of Fig. 1;

Figs. 4A through 4E are waveform diagrams of output signals of the pulse encoder of Fig. 1; and

Fig. 5 is a perspective view of a conventional air speedometer using optical fibers.

DESCRIPTION OF THE PREFERRED EMBODIMENTS

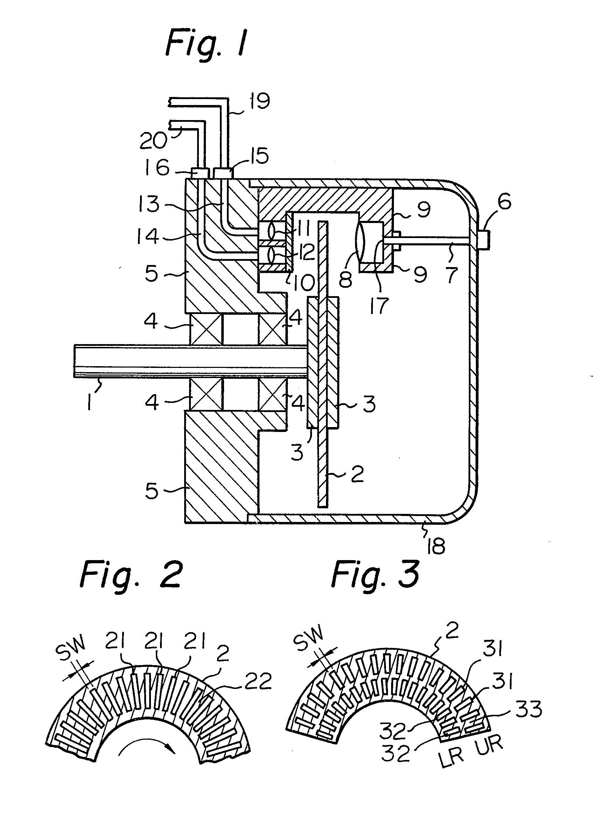

Figure 1 illustrates a pulse encoder according to the present invention. In Fig. 1, reference numeral 1 represents a rotational-free shaft to be connected to a rotor shaft of a servomotor (not shown). A rotary lattice disc 2 is fixed to the shaft 1 with pressing plates 3. The shaft 1 engages, via bearings 4, with an outer frame 5. According to the present invention, an input optical fiber 7 is connected to an input optical connector 6. Opposite to the output end 17 of the input optical fiber 7, a first lens 8 is fixed to a stage 9, which is fixed to the outer frame 5. The first lens 8 converts the light rays radiated from the output end 17 of the input optical fiber 7 into parallel light rays. A stationary lattice plate 10 is mounted on the stage 9 so that it is opposite the rotary lattice disc 2 and opposite the first lens 8 with respect to the rotary lattice disc 2. The rotary lattice disc 2 and the stationary lattice plate 10 are well known and are made of glass or thin metal plate, and, as is illustrated in Figs. 2 and 3, respectively, their surfaces are processed by chrome evaporation and then etching is carried out to form transparent slits 21, 31, and 32 and opaque portions 22 and 33, there being a predetermined distance between the adjacent slits. In this embodiment, as is illustrated in Fig. 3, an upper row UR and a lower row LR of slits are provided on the stationary lattice plate 10, the width of each slit 31 and 32 being substantially the same as the width of each slit 21 of the rotary lattice disc 2 and the distance between the adjacent slits in the stationary lattice plate 10 being substantially the same as that in the rotary lattice disc 2. The lower slits 32 have a phase which is shifted by half of the slit width SW with respect to the upper slits 31. The light rays transmitted through the upper slits 31 and the lower slits 32 are modified into light intervals and dark intervals. These modified light rays are focused by second lenses 11 and 12. The second lenses 11 and 12 are mounted on the stage 9 and are arranged opposite the rotary lattice disc 2 with respect to the stationary lattice plate 10. The focused light rays are transmitted, according to the present invention, through output optical fibers 13 and 14 to output optical connectors 15 and 16. Reference numeral 18 represents a protective case for the pulse encoder.

As is apparent from Fig. 1, unlike a conventional pulse encoder, the pulse encoder of this embodiment does not include, in its interior, a light source, a light-receiving semiconductor element, or a signal amplifier having semiconductor elements. Therefore, even if the pulse encoder is included in a servomotor, the reliability of the pulse encoder is not deteriorated by an increase in the temperature of the motor. Also, by transmitting the signals from the output optical connectors 15 and 16 by means of optical fibers 19 and 20, noises due to external electromagnetic induction or waveform deterioration due to floating capacitances is greatly reduced in comparison with the prior art, with the result that it is possible to extend the transmission length from the output optical connectors 15 and 16 to a light-receiving semiconductor element (not shown) to more than several times that of the prior art.

Due to the provision of the first lens 8 between the input optical fiber 7 and the rotary lattice disc 2, the light rays from the input optical fiber 7 are made almost parallel, with the result that the light/dark ratio, i.e., the ratio of the intensity of the light in the light

- 5 -

intervals to the intensity of the light in the dark intervals, is virtually not decreased due to the leakage of light between the first lens 8 and the second lenses 11 and 12 and the dispersion of light can be prevented.

Further, by providing the focusing second lenses 11 and 12, the light rays transmitted through the rotary lattice disc 2 are further focused, and thereby the light/dark ratio is further improved, in turn resulting in an improvement of S/N in the output of the pulse encoder.

Since the light/dark ratio is improved as described above, the distance between the adjacent slits and the width of each slit in the rotary lattice disc 2 or in the stationary lattice plate 10 need not be as large as in a conventional pulse encoder. The width of each slit and the distance between the adjacent slits are both smaller than or equal to the diameter of the output optical fiber 13 or 14. Therefore, the number of slits in the rotary lattice disc 2 can be greatly increased in comparison with the prior art. This means that, according to the present invention, the number of pulses per one rotation is increased in comparison with the prior art under the assumption that the diameter of the rotary lattice disc 2 is the same as that of the conventional rotary lattice disc, with the result that the rotation angle and the rotating speed of a servomotor can be determined with a high accuracy.

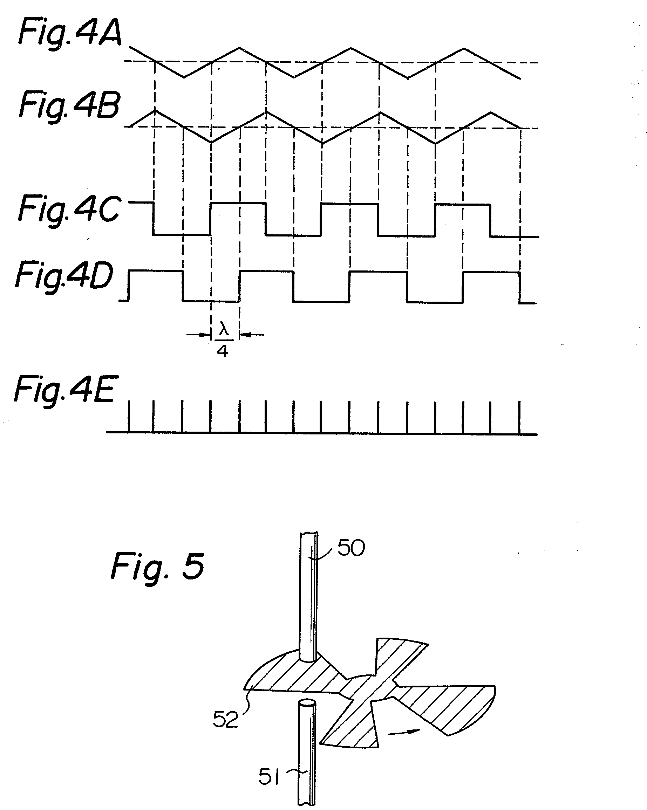

Further, as can be seen from Fig. 3, the slits 31 in the upper row UR and the slits 32 in the lower row LR are phase shifted toward each other by 1/4 of a wavelength (90°), whereby the rotating direction of the rotary lattice disc 2 can be determined. This determination of the rotating direction is explained with reference to the waveform diagrams of Figs. 4A and 4B.

The optical signals obtained from the output optical connectors 15 and 16 are transmitted through the optical fibers 19 and 20 to a photo diode (not shown) and are converted into electric signals. The electirc signals are then amplified by first and second signal amplifiers (not

- 6 -

shown), respectively. When the rotary lattice disc 2 rotates in a clockwise direction (in the direction of the arrow in Fig. 2) with respect to the stationary lattice plate 10, the waveform of Fig. 4A can be obtained at the output of the first signal amplifier corresponding to the output optical connector 15, and the waveform of Fig. 4B, which is delayed by 1/4 of a wavelength with respect to the waveform of Fig. 4A, can be obtained at the output of the second signal amplifier corresponding to the output optical connector 16. When the rotary lattice disc 2 rotates in a counterclockwise direction, the phase relationship between the signal at the output of the first signal amplifier and the signal at the output of the second signal amplifier is inverted. Thus, the rotating direction of the rotary lattice disc 2 can be determined from the phase relationship between the waveforms of Figs. 4A and 4B.

The output signals of the signal amplifiers are then converted by rectangular waveform convertors (not shown) into signals having rectangular waveforms, as is shown in Figs. 4C and 4D, respectively. From the rises and falls of the waveform of Fig. 4C and the rises and falls of the waveform of Fig. 4D, a series of pulse signals shown in Fig. 4E is obtained. Since two waveforms are used to obtain the output pulses, the frequency of the output pulses is doubled in comparison with a case where only one row of slits is provided in the stationary lattice plate 10. This doubled frequency of the output pulses ensures a high resolution of a pulse encoder.

In the aforementioned embodiment, the upper row UR and the lower row LR of slits are provided in the stationary lattice plate 10. However, the object of the present invention can be attained even if only one row of slits having the same pitch as the pitch of the rotary lattice disc 2 is provided. In this case, in place of the second lenses 11 and 12, a single lens and a single output optical fiber are used.

As a tachometer using an optical fiber, the air speedometer illustrated in Fig. 5 is conventionally known. In Fig. 5, light rays between an optical fiber 50 on the light source side and an optical fiber 51 on the light--receiving side are intermittently cut by a light-cutting plate 52 which rotates in accordance with the velocity of the wind. Thus, the velocity of the wind is determined by the pulses obtained from the optical fiber 51 on the light--receiving side. This conventional air speedometer determines the rotating speed by using optical fibers, as in the present invention. However, when the distance between the adjacent slits of the light-cutting plate 52 is smaller than the diameter of the fiber, the ratio of the intensity of the light in the light intervals to the intensity of the light in the dark intervals becomes small due to the leakage of light. To avoid this, the distance between the optical fiber 50 and the optical fiber 51 must be small. Therefore, this conventional air speedometer cannot be applied to. determine the rotation angle or the rotating speed of a servomotor.

As is described above, according to the present invention, by providing no semiconductor element within a pulse encoder and by using optical fibers and lenses, the reliability of a pulse encoder is greatly improved, the transmission characteristics of the output signal is improved, and the S/N ratio and the accuracy of the output signal are improved.

0090576

- 8 -

<u>CLAIMS</u>

1. A pulse encoder comprising:

an input optical fiber for transmitting light rays from an input optical connector;

a first lens for receiving light rays from the output end of said input optical fiber and for modifying the received light rays into parallel light rays;

a rotary lattice disc fixed to a rotary shaft, said rotary lattice disc having a plurality of first slits for transmitting a part of said parallel light rays;

a stationary lattice plate fixed to a frame of said pulse encoder, said stationary lattice plate having a plurality of second slits for transmitting a part of said parallel light rays output by said rotary lattice disc, the width of each of said first slits being the same as the width of each of said second slits;

a second lens system for focusing parallel light rays transmitted through said rotary lattice disc and said stationary lattice plate; and

at least one output optical fiber for transmitting the focused light rays to an output optical connector.

2. A pulse encoder as set forth in claim 1, wherein the width of each of said first slits is substantially the same as the distance between the adjacent slits of said first slits, the width of each of said second slits is substantially the same as the distance between the adjacent slits of said second slits, and said stationary lattice plate has a first row of said second slits and a second row of said second slits, the difference between the first phase of said first row of said second slits and the second phase of said second row of said second slits being 1/4 of a wavelength, the wavelength being determined by the width of each slit and the distance between the adjacent slits of said first or second slits.

3. A pulse encoder as set forth in claim 2, wherein said second lens system comprises two lenses fixed to said frame, one of said two lenses corresponding to said first row of said second slits and the other of said two lenses corresponding to said second row of said second slits.

4. A pulse encoder as set forth in claim 3, wherein said at least one output optical fiber comprises two output optical fibers, one of said two output optical fibers being adapted to receive focused light rays from said one of said two lenses in said second lens system and the other of said two lenses being adapted to receive focused light rays from said the other of said two lenses in said second lens system.

0090576

1/2

Fig. 1

Fig. 2

Fig. 3

0090576

2/2

Fig.4A

Fig.4B

Fig.4C

Fig.4D

$\frac{\lambda}{4}$

Fig.4E

Fig. 5

50

52

51